# FASCICULE DE BREVET EUROPEEN

(11) **EP 0 564 359 B1**
(45) Date de publication et mention de la délivrance du brevet: **04.09.1996**
(21) Numéro de dépôt: 93400845.9
(22) Date de dépôt: 01.04.1993
(51) Int. Cl.: H05H 1/46, H01J 37/32, H01P 7/06, H05B 6/70

(54) **Dispositif d'application de micro-ondes et réacteur à plasma utilisant ce dispositif**
Mikrowellenstrahler und Plasmareaktor unter Verwendung dieser Einrichtung
Microwave applicator and plasma reactor using the same

(30) Priorité: 03.04.1992 FR 9204079
(43) Date de publication de la demande: 06.10.1993
(73) Titulaire: COMMISSARIAT A L'ENERGIE ATOMIQUE, 75015 Paris (FR)
(72) Inventeur: Charlet, Barbara, F-38330 Montbonnot-Saint-Martin (FR)
(74) Mandataire: Dubois-Chabert, Guy

(56) Documents cités:
- EP-A- 0 252 542
- EP-A- 0 398 832
- WO-A-90/03093
- DE-A- 3 905 303
- DE-A- 3 915 477
- PATENT ABSTRACTS OF JAPAN vol. 13, no. 476 (E-837)16 Octobre 1989 & JP-A-11 87 824
- PATENT ABSTRACTS OF JAPAN vol. 14, no. 106 (C-694)27 Février 1990 & JP-A-13 09 973
- PATENT ABSTRACTS OF JAPAN vol. 12, no. 297 (C-519)12 Août 1988 & JP-A-63065077
- PATENT ABSTRACTS OF JAPAN vol. 13, no. 16 (E-703)13 Janvier 1989 & JP-A-63 222 424

## Description

La présente invention concerne un dispositif d'application de micro-ondes.

Elle s'applique à l'irradiation d'un matériau par les micro-ondes, le mot "matériau" signifiant toute matière sous forme solide, liquide ou gazeuse.

La présente invention s'applique notamment à l'irradiation d'un gaz en vue d'engendrer un plasma.

L'invention s'applique également à la réalisation
- de sources d'espèces réactives, par exemple pour l'élaboration de couches minces ou la formation de poudres,
- de sources d'espèces chargées telles que les électrons et les ions ou de sources d'espèces neutres (atomes ou molécules) excitées ou non, par exemple pour le traitement des surfaces,
- de sources lumineuses, par exemple pour le pompage laser ou pour la spectroscopie.

On connaît déjà divers dispositifs d'application de micro-ondes, notamment pour la formation d'un plasma, par exemple du document EP-A-0 398 832 ou de JP-A-1-187 824.

Cependant, le plasma ainsi formé est généralement peu homogène, difficile à amorcer et à adapter (il est difficile d'obtenir un bon rapport entre l'énergie de l'onde électromagnétique introduite dans le dispositif pour former le plasma et l'énergie de l'onde électromagnétique absorbée par le plasma) ; de plus, le plasma présente des instabilités locales qui se manifestent comme des changements de caractéristiques telles que la luminosité, la densité d'espèces, la répartition de ces espèces à l'intérieur du volume où est établi le plasma ; l'établissement de ce plasma n'est possible que dans une gamme restreinte de pressions et dans de faibles volumes.

La présente invention a pour but de remédier à ces inconvénients en proposant un dispositif d'application de micro-ondes permettant notamment de former et d'entretenir un plasma de grand volume et de bonne homogénéité.

La présente invention a pour objet un dispositif d'application de micro-ondes à un matériau, dispositif caractérisé en ce qu'il comprend au moins un module d'application des micro- ondes au matériau, ce module comprenant :
- une cavité résonante sensiblement en forme de couronne et délimitée par des parois interne, externe, inférieure et supérieure qui sont électriquement conductrices, et
- au moins un guide d'ondes prévu pour amener les micro-ondes dans cette cavité résonante, les dimensions de la section de la cavité par un plan contenant l'axe de cette cavité étant choisies en fonction des dimensions de la section transversale du guide d'ondes de façon que le mode qui se propage dans la cavité soit identique au mode de propagation des micro-ondes dans le guide d'ondes,
   et en ce qu'au moins l'une des parois de la cavité résonante est pourvue de fentes rayonnantes qui sont espacées les unes des autres d'une distance au plus égale à Lg/2 où Lg est la longueur d'onde des micro-ondes dans le guide d'ondes, ce guide d'ondes ayant lui-même une longueur au moins égale à Lg/2,
   de façon à transférer, à travers ces fentes, de l'énergie électro-magnétique au matériau disposé à cet effet en regard de la paroi portant les fentes rayonnantes.

Le dispositif objet de l'invention permet d'obtenir un couplage entre une onde hyper-fréquence progressive, provenant d'un générateur haute fréquence, et un plasma, dans la gamme des fréquences allant d'environ 0,3 GHz à 30 GHz par exemple.

Ce plasma est formé dans une enceinte remplie d'un ou plusieurs gaz appropriés, à une pression par exemple comprise entre 0,1 Pa et quelques milliers de Pa ; le dispositif permet un transfert d'énergie électromagnétique entre l'onde incidente de haute fréquence et un volume du gaz que l'on veut exciter pour former le plasma ; ce transfert d'énergie se produit par l'intermédiaire des fentes rayonnantes ; la structure du dispositif et la disposition des fentes permettent une répartition homogène de l'énergie électromagnétique dans l'enceinte contenant le plasma ; ce dispositif fournit une énergie électro-magnétique d'excitation dont la distribution permet la formation et l'entretien d'un plasma de grand volume.

Le diamètre intérieur de la couronne du dispositif ne dépend pas de la fréquence de l'onde électromagnétique incidente mais les dimensions de cette couronne sont choisies de façon à satisfaire aux conditions de propagation d'un mode principal, le mode TE10 par exemple.

Les fentes rayonnantes du dispositif objet de l'invention peuvent être situées sur l'une au moins des parois interne et externe ou sur l'une au moins des parois inférieure et supérieure.

Selon un mode de réalisation particulier du dispositif objet de l'invention, l'une au moins des parois interne et externe est cylindrique.

Selon un autre mode de réalisation particulier du dispositif objet de l'invention, l'une au moins des parois interne et externe est en forme de polyèdre régulier, ayant ainsi une pluralité de facettes identiques, et lorsque la paroi externe a cette forme de polyèdre régulier la longueur de ses facettes est au moins égale à Lg/4.

Dans une réalisation particulière, le guide d'ondes est prolongé par un cornet sectoral suivi par un duplexeur qui amène les micro-ondes à la cavité résonante et la longueur de l'ensemble formé par le cornet sectoral et le duplexeur est au moins égale à Lg/2.

Le dispositif objet de l'invention peut comprendre en outre au moins un court-circuit fixe pour chaque guide d'ondes, ce court-circuit fixe formant un obstacle plan électriquement conducteur qui est perpendiculaire aux parois inférieure et supérieure de la cavité résonante et qui s'étend sur toute la section de celle-ci par un plan contenant l'axe de la cavité.

La position du ou des courts-circuits est déterminée par le nombre d'arrivées d'énergie micro-ondes et par la configuration du rayonnement par les fentes que l'on souhaite obtenir. La fonction de ce ou ces courts-circuits est de diminuer le taux de fuite d'énergie dans la cavité et d'augmenter le rendement de couplage entre l'onde électro-magnétique et le matériau. Ce ou ces courts-circuits sont avantageusement placés de façon à obtenir une symétrie de rayonnement émis par les fentes du dispositif.

Dans le mode de réalisation particulier où le guide d'ondes est prolongé par le cornet sectoral suivi par le duplexeur, le dispositif comprend de préférence deux tels courts- circuits, l'un étant disposé entre les entrées de micro-ondes, entrées qui sont respectivement associées aux branches du duplexeur, et l'autre étant symétrique du précédent par rapport à l'axe de la cavité.

Dans le cas de la génération d'un plasma, on améliore ainsi grandement l'homogénéité de la répartition de ce plasma.

Le dispositif objet de l'invention peut comprendre en outre une plaque ou une grille électriquement conductrice qui ferme la partie supérieure de ce dispositif.

La présente invention a également pour objet un réacteur à plasma comprenant :
- une enceinte dont au moins une partie est faite d'un matériau transparent aux micro-ondes et qui est prévue pour recevoir un gaz plasmagène, et
- un dispositif d'application de micro-ondes au gaz, ce dispositif étant disposé en regard de la partie faite d'un matériau transparent aux micro-ondes, de façon à engendrer un plasma dans l'enceinte et à traiter, grâce à ce plasma, un ou plusieurs échantillons placés dans l'enceinte,
   ce réacteur étant caractérisé en ce que le dispositif d'application des micro-ondes est conforme à celui qui fait aussi l'objet de l'invention.

Selon un mode de réalisation particulier de ce réacteur, les fentes du dispositif qu'il comporte sont situées sur la paroi interne de la cavité résonante et ladite partie du réacteur est entourée par le dispositif.

Selon un autre mode de réalisation particulier, le réacteur comprend une pluralité de modules qui sont placés les uns à la suite des autres et qui entourent ladite partie du réacteur.

Selon un autre mode de réalisation particulier, les fentes du dispositif sont situées sur la paroi inférieure de la cavité résonante et ladite partie du réacteur est placée en regard de cette paroi inférieure.

La présente invention sera mieux comprise à la lecture d'exemples de réalisation donnés ci-après à titre purement indicatif et nullement limitatif, en faisant référence aux dessins annexés sur lesquels :
- la figure 1 est une vue schématique d'un mode de réalisation particulier du dispositif objet de l'invention,
- la figure 2 est une vue schématique d'un autre mode de réalisation particulier de ce dispositif, dans lequel un cornet sectoral et un duplexeur sont utilisés pour amener les micro-ondes dans la cavité que comporte le dispositif,
- la figure 3 est une vue en coupe schématique d'un réacteur à plasma comportant un dispositif conforme à la présente invention,
- la figure 4 est une vue schématique d'un système d'alimentation du dispositif de la figure 3 en énergie électromagnétique,
- la figure 5 est une vue en coupe schématique d'un autre réacteur à plasma conforme à l'invention, dans lequel plusieurs dispositifs conformes à l'invention sont associés,
- la figure 6 est une vue schématique d'un dispositif conforme à l'invention, comportant des fentes rayonnantes sur sa paroi externe,
- la figure 7 est une vue schématique d'un autre dispositif conforme à l'invention, comportant des fentes rayonnantes sur sa paroi inférieure,
- la figure 8 est une vue de dessus schématique d'un dispositif conforme à l'invention, comportant deux guides d'onde pour amener les micro-ondes dans la cavité résonante du dispositif, et
- la figure 9 est une vue de dessus schématique d'un autre dispositif conforme à l'invention, comportant deux cornets sectoraux et deux duplexeurs pour amener les micro-ondes dans la cavité résonante du dispositif.

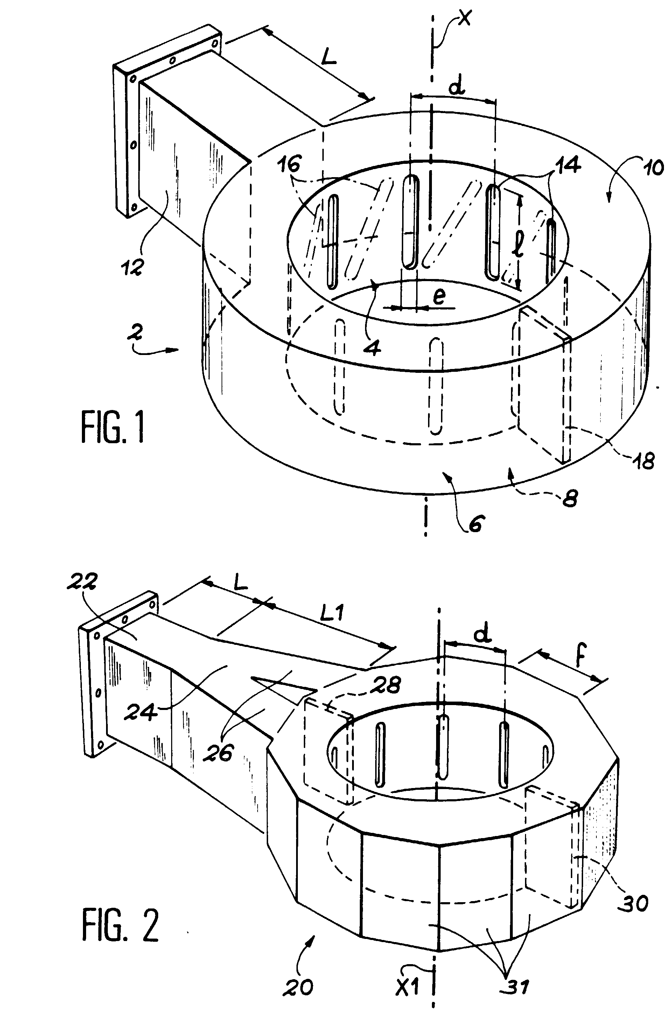

Le dispositif d'application de micro-ondes conforme à l'invention, qui est schématiquement représenté en perspective sur la figure 1, comprend une cavité résonante 2 en forme de couronne et délimitée par une paroi interne 4, une paroi externe 6, une paroi inférieure 8 et une paroi supérieure 10 qui sont électriquement conductrices, et
- un guide d'ondes 12 qui est prévu pour amener les micro-ondes dans la cavité résonante 2.

Les micro-ondes (de type UHF) sont émises par un générateur non représenté et transmises par un guide d'onde ou un câble (non représenté) jusqu'au guide d'onde 12, de forme parallélépipédique, qui permet la propagation d'un mode dominant, par exemple le mode TE10.

La longueur L du guide d'ondes 12 est supérieure ou égale à Lg/2, où Lg représente la longueur d'onde des micro-ondes dans le guide 12.

La quantité Lg est une valeur caractéristique pour une fréquence de propagation, un mode de propagation et des dimensions données du guide d'ondes 12.

L'intérieur du guide 12 (de type standard) communique avec l'intérieur de la couronne 2, par l'intermédiaire d'une ouverture prévue à cet effet sur la couronne.

La paroi interne 4 et la paroi externe 6 sont cylindriques et coaxiales, comme on le voit sur la figure 1, et la paroi inférieure 8 et la paroi supérieure 10 sont planes et parallèles.

De plus, les dimensions de la section de la couronne 2 par un plan contenant son axe X sont égales aux dimensions correspondantes de la section transversale du guide d'ondes 12, la couronne 2 ayant ainsi la même "géométrie" que le guide 12.

Ainsi, dans la cavité en forme de couronne 2 se propage le même mode que celui qui se propage dans le guide d'ondes 12.

La couronne 2 ferme la ligne de propagation des ondes UHF.

En ce qui concerne les dimensions de la cavité 2 et du guide d'ondes 12, on ajoutera que cette cavité 2 et ce guide 12 sont tous deux de type "plan E" ou sont tous deux de type "plan H".

On voit que le dispositif représenté sur la figure 1 est de type "plan H".

La paroi interne 4 de la couronne 2 est pourvue de fentes rayonnantes 14 qui sont perpendiculaires aux faces inférieure 8 et supérieure 10 et qui sont équidistantes les unes des autres.

La disposition de ces fentes respecte les distances caractéristiques de propagation des micro-ondes dans le guide.

Plus précisément, la distance d entre deux fentes consécutives est inférieure ou égale à Lg/2.

On précise que la longueur l d'une fente est environ égale à Lo/2, où Lo est la longueur d'onde des micro-ondes dans l'air, et que la largeur e de cette fente est beaucoup plus petite que la dimension du plus petit côté du guide d'onde 12 (vu en coupe transversale), c'est-à-dire que e est au moins 5 fois plus petit que la dimension de ce plus petit côté du guide 12.

Dans une variante de réalisation, que l'on voit en traits mixtes sur la figure 1, les fentes rayonnantes (alors référencées 16) sont parallèles et équidistantes les unes des autres mais inclinées par rapport aux parois 8 et 10 de la cavité.

Le dispositif représenté sur la figure 1 permet de transférer de l'énergie électromagnétique à un matériau (non représenté) disposé dans l'espace délimité par la paroi interne 4 de la couronne 2 mais, dans d'autres modes de réalisation, des fentes rayonnantes supplémentaires pourraient être prévues sur une ou plusieurs autres parois de la cavité de façon à transférer de l'énergie électromagnétique dans des zones situées en regard de cette ou ces autres parois.

En revenant au mode de réalisation représenté sur la figure 1, un court-circuit fixe 18 est de préférence prévu dans la cavité résonante 2 pour séparer cette cavité en deux zones de propagation des micro-ondes.

On améliore ainsi l'homogénéité de la répartition des micro-ondes dans le matériau disposé dans la zone délimitée par la paroi interne 4.

Ce court-circuit 18 constitue un obstacle plan électriquement conducteur qui est perpendiculaire aux parois 8 et 10.

Le court-circuit 18, dont les dimensions sont respectivement égales aux dimensions de la section de la cavité 2 par un plan contenant son axe X, est disposé suivant ce plan et à l'opposé du guide d'ondes 12 par rapport à l'axe X, de façon à partager cette cavité en deux zones de rayonnement égales.

Dans l'exemple représenté sur la figure 1, le court- circuit 18 est situé au niveau de l'une des fentes 14 prévue sur la paroi interne 4 mais, dans d'autres exemples, il pourrait être situé au niveau de parties sans fentes des parois 4 et 6.

Le dispositif conforme à l'invention qui est schématiquement représenté sur la figure 2 comprend encore une cavité résonante 20 sensiblement en forme de couronne ainsi qu'un guide d'ondes 22 du genre du guide d'ondes 12 de la figure 1.

De plus, un cornet sectoral plan 24 muni d'un duplexeur 26, dont on voit les deux branches sur la figure 2, est interposé entre le guide 24 et la cavité 20 de sorte que les micro-ondes sont amenées à l'intérieur de cette cavité successivement par le guide 22, le cornet sectoral 24 et le duplexeur 26.

Bien entendu, la longueur L du guide 22 est encore supérieure ou égale à Lg/2.

De même, la longueur L1 de l'ensemble du cornet sectoral et du duplexeur est au moins égale à Lg/2.

Les dimensions de la section de la cavité 20 par un plan contenant son axe X1 sont encore choisies en fonction des dimensions de la section transversale du guide d'ondes 22 de façon que le mode qui se propage dans la cavité 20 soit identique au mode de propagation des micro-ondes dans le guide 22.

Suivant que le guide d'ondes 22 est de type "plan E" ou de type "plan H", on choisira un cornet sectoral de type "plan E" ou de type "plan H".

Dans le cas où l'on utilise un cornet sectoral muni d'un duplexeur, il est préférable de prévoir deux courts-circuits 28 et 30 dans la cavité, comme on le voit sur la figure 2.

L'un des courts-circuits, portant la référence 28, est disposé entre les deux ouvertures par l'intermédiaire desquelles les branches du duplexeur communiquent avec l'intérieur de la cavité tandis que l'autre court-circuit 30 est disposé dans la cavité, symétriquement au court-circuit 28 par rapport à l'axe X1 de la cavité.

De cette façon, on obtient deux cavités résonantes à l'intérieur de la couronne 20.

Dans un mode de réalisation particulier qui est également illustré sur la figure 2, les parois interne et externe de la cavité résonante ne forment plus deux cylindres coaxiaux : l'une d'entre elles conserve cette forme de cylindre dont l'axe est X1 tandis que l'autre (la paroi externe dans l'exemple représenté sur la figure 2) a la forme d'un polyèdre régulier composé d'une pluralité de facettes 31 identiques et parallèles à l'axe X1 de la cavité.

Dans le cas où la paroi externe a cette forme de polyèdre régulier, la longueur f de chacune de ses facettes 31 doit être supérieure ou égale à Lg/4 (cas d'un guide assurant la propagation d'un mode dominant, par exemple TE10).

Dans un autre mode de réalisation particulier, on pourrait même avoir une cavité résonante dont les parois interne et externe formeraient toutes deux des polyèdres réguliers.

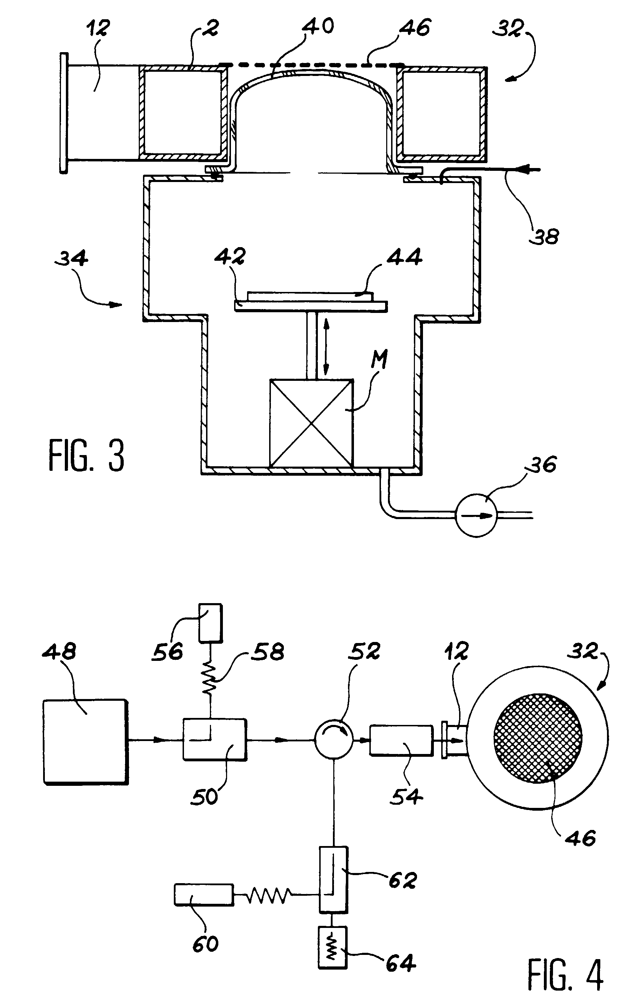

Sur la figure 3, on a représenté schématiquement, en coupe longitudinale, un réacteur à plasma utilisant un dispositif d'application de micro-ondes 32 conforme à l'invention, par exemple le dispositif représenté sur la figure 1.

Le réacteur de la figure 3 comprend également une enceinte 34 munie de moyens de pompage 36 permettant de faire le vide dans cette enceinte 34 ainsi que de moyens 38 permettant d'introduire un ou plusieurs gaz plasmagènes dans l'enceinte 34.

De plus, comme on le voit sur la figure 3, la partie supérieure 40 de l'enceinte 34 forme un dôme 40.

Cette partie en forme de dôme est faite d'un matériau diélectrique, le quartz par exemple.

Le dispositif d'application des micro-ondes 32 est disposé au niveau de cette partie 40, cette dernière étant placée dans la zone délimitée par la paroi interne du dispositif 32.

Les ondes progressives issues du dispositif 32 traversent le dôme de quartz 40 et excitent le gaz contenu dans le réacteur.

Un plasma s'amorce, après quoi le couplage entre les micro-ondes issues du dispositif 32 et le plasma permet d'entretenir ce dernier.

Un porte-subtrat 42 muni de moyens M permettant son réglage selon la hauteur est placé dans l'enceinte 34.

Un ou plusieurs substrats 44 sont placés sur le porte- substrat 42 pour être traités par le plasma formé dans l'enceinte 34.

Un dispositif conforme à l'invention autorise un diamètre important pour la décharge, par exemple un diamètre supérieur à 150 millimètres pour une fréquence des micro-ondes égale à 2,45 GHz.

Suivant le générateur de micro-ondes utilisé (non représenté sur la figure 3), il est possible d'obtenir un fonctionnement en régime continu ou en régime pulsé (avec l'existence d'une post-décharge temporelle) pour le réacteur à plasma.

On peut éventuellement associer un champ magnétique à la décharge pour obtenir un confinement du plasma, lorsque l'intensité de l'induction magnétique est inférieure à 875x10⁻⁴ T, ou pour obtenir des conditions de résonance cyclotronique électronique, lorsque l'intensité de l'induction magnétique est supérieure à 875x10⁻⁴ T, pour une fréquence d'excitation égale à 2,45 GHz.

Comme on le voit sur la figure 3, la partie supérieure du dispositif d'application conforme à l'invention peut être fermée par une plaque ou une grille 46 faite d'un matériau électriquement conducteur, formant une surface équipotentielle avec la paroi supérieure du guide d'ondes 12.

Cette surface équipotentielle, qui est située au-dessus du dôme 40 du matériau diélectrique, empêche le rayonnement du champ électromagnétique vers l'extérieur.

On choisira une grille dans le cas d'une utilisation prolongée du plasma, la grille permettant dans ce cas l'évacuation de la chaleur produite à l'intérieur du dispositif d'application des micro-ondes.

Sur la figure 4, on a représenté schématiquement une installation permettant d'envoyer les micro-ondes vers le dispositif d'application 32 qui est vu de dessus et monté sur la réacteur de la figure 3.

L'installation schématiquement représentée sur la figure 4 comprend un générateur UHF à puissance variable qui fournit les micro-ondes au guide d'ondes 12 du dispositif 32, successivement par l'intermédiaire d'un coupleur directionnel 50, d'un circulateur 52 et d'un moyen d'adaptation d'impédance 54.

On voit aussi sur la figure 4 un moyen de mesure de la puissance incidente 56, qui est relié au coupleur directionnel 50 par l'intermédiaire d'un atténuateur 58.

On voit également un moyen de mesure de la puissance réfléchie 60 qui est relié au circulateur 52 par l'intermédiaire d'un autre coupleur directionnel 62 muni d'une charge adaptée 64.

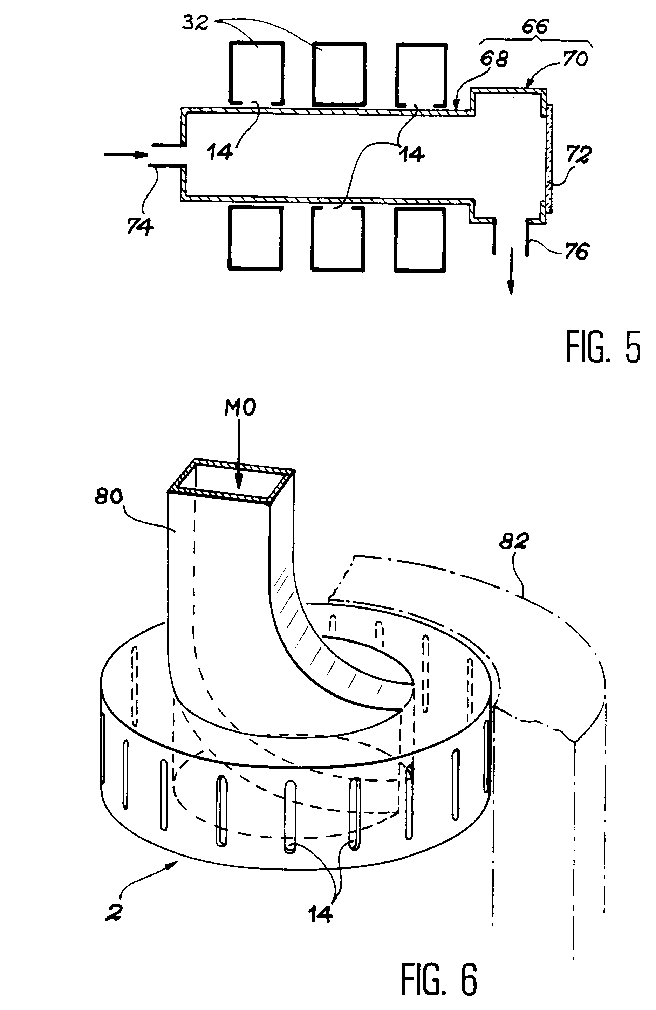

La figure 5 illustre la possibilité d'engendrer un plasma de grand volume dans une zone délimitée par une paroi de forme allongée, faite d'un matériau diélectrique, au moyen de plusieurs dispositifs conformes à l'invention, du genre du dispositif de la figure 1 par exemple, qui sont placés les uns à la suite des autres et entourent cette paroi diélectrique.

Plus précisément, on voit sur la figure 5 un réacteur à plasma 66 comprenant une partie 68 faite d'un matériau diélectrique, cette partie 68 ayant une forme allongée, par exemple cylindrique, ainsi qu'une autre partie 70 raccordée à la partie 68 et munie de moyen 72 permettant d'introduire des échantillons que l'on veut traiter par plasma à l'intérieur du réacteur.

La partie 68 du réacteur est munie de moyens 72 permettant d'introduire un gaz plasmagène ou un mélange de gaz plasmagène dans la zone du réacteur qui est délimitée par cette partie 68 et qui constitue une zone de décharge.

L'autre partie 70 du réacteur, qui délimite une zone de post-décharge, est munie de moyens 76 de pompage des gaz introduits.

Le réacteur représenté sur la figure 5 comprend également une pluralité de dispositifs d'application de micro- ondes 32 conformes à l'invention, par exemple du genre du dispositif représenté sur la figure 1.

Ces dispositifs 32 sont disposés les uns à la suite des autres autour de la partie 68 faite d'un matériau diélectrique, cette dernière traversant ainsi les zones des dispositifs 32 qui sont délimitées par les parois internes de ces dispositifs.

On est ainsi capable de créer un plasma de grand volume dans le réacteur de la figure 5.

Il est possible d'aligner ou de décaler la position des fentes 14 d'un dispositif d'application 32 par rapport à un dispositif d'application voisin (comme on le voit sur la figure 5) afin d'avoir des zones de rayonnement dans le même plan ou décalées.

Sur la figure 6, on a représenté schématiquement un autre dispositif d'application conforme à l'invention dans lequel les fentes rayonnantes 14 sont disposées sur la paroi externe de la cavité résonante 2.

Dans ce cas, on adjoint à la cavité un guide d'ondes 80 qui amène les micro-ondes MO à cette cavité et qui se raccorde, en se courbant, à cette dernière par une ouverture formée sur la paroi interne de la cavité 2, comme on le voit sur la figure 6.

L'énergie électromagnétique rayonnée par les fentes 14 peut alors servir à l'entretien d'un plasma dans une enceinte annulaire 82 qui est faite d'un matériau transparent aux micro- ondes et qui entoure la cavité résonante 2 de sorte que la paroi interne de cette enceinte 82 se trouve en regard de la paroi externe de la cavité résonante 2 comme on le voit sur la figure 6.

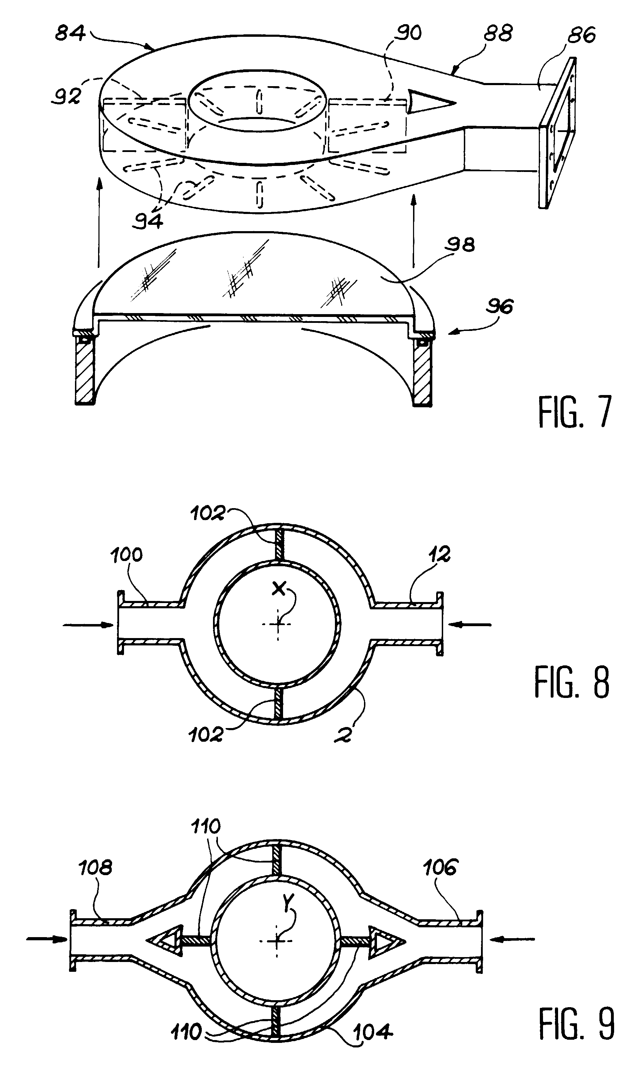

Le dispositif d'application de micro-ondes conforme à l'invention, qui est schématiquement représenté sur la figure 7, comprend encore une cavité résonante 84 en forme de couronne, alimentée par un guide d'ondes 86, par l'intermédiaire d'un ensemble 88 constitué par un cornet sectoral et d'un duplexeur.

Comme dans le cas de la figure 2, le dispositif de la figure 7 comprend deux courts-circuits 90 et 92, l'un de ces courts-circuits étant placé entre les ouvertures de la cavité où aboutissent les branches du duplexeur tandis que l'autre court- circuit est diamétralement opposé au précédent.

Dans le cas de la figure 7, les fentes rayonnantes sont disposées sur la paroi inférieure de la cavité 84, ces fentes étant équidistantes les unes des autres et disposées radialement sur cette paroi inférieure de sorte que l'énergie électromagnétique est rayonnée vers le bas de la cavité résonante.

Le dispositif de la figure 7 est utilisable pour entretenir un plasma dans une enceinte 96 dont on voit seulement la partie supérieure sur la figure 7, cette partie supérieure étant fermée de façon étanche par une paroi plane 98 de forme circulaire, qui est faite d'un matériau diélectrique comme le quartz et dont le diamètre est sensiblement égal au diamètre externe de la cavité résonante 84.

Le dispositif d'application de micro-ondes représenté sur la figure 7 est disposé de façon que sa paroi inférieure soit au voisinage de la paroi 98 en quartz et soit superposée à cette dernière pour que les micro-ondes rayonnées par les fentes 94 pénètrent dans l'enceinte 96 à travers la paroi 98.

Les figures 8 et 9 montrent des dispositifs d'application de micro-ondes conformes à l'invention et comportant plusieurs arrivées de micro-ondes.

Plus précisément, le dispositif conforme à l'invention qui est schématiquement représenté sur la figure 8 en vue de dessus comporte encore la cavité résonante 2 de la figure 1, munie du guide d'ondes 12 amenant des micro-ondes dans cette cavité et, en plus, un autre guide d'ondes 100 qui est du genre du guide d'ondes 12 et permet d'amener également des micro-ondes 2 dans la cavité résonante 2, ce guide 100 étant symétrique du guide 12 par rapport à l'axe X de la cavité.

Dans le cas de la figure 8, on prévoit de préférence autant de courts-circuits 102 que d'arrivées de micro-ondes, c'est-à-dire deux courts-circuits, ces deux courts-circuits étant équidistants des guide 12 et 100 et diamétralement opposés l'un à l'autre dans la cavité résonante 2.

Le dispositif d'application de micro-ondes schématiquement représenté sur la figure 9 en vue de dessus comprend encore une cavité résonante 104 en forme de couronne munie d'un ensemble 106 comprenant successivement un guide d'ondes, un cornet sectoral et un duplexeur pour amener les micro- ondes dans la cavité 104 (comme on l'a vu dans le cas de la figure 2) ainsi qu'un autre ensemble 108 qui est identique à l'ensemble 106 et symétrique de celui-ci par rapport à l'axe Y de la cavité résonante 104 en vue d'amener également des micro-ondes dans cette cavité résonante.

Dans le cas de la figure 9, on utilise de préférence quatre courts-circuits 110 (c'est-à-dire de ces courts-circuits par arrivée de micro-ondes), deux de ces courts-circuits étant disposés symétriquement l'un de l'autre par rapport à l'axe Y et équidistants des ensembles 106 et 108, tandis que les deux autres courts-circuits sont disposés dans la cavité résonante 104 symétriquement l'un de l'autre par rapport à l'axe Y de la cavité, entre les ouvertures par lesquelles les branches des duplexeurs sont raccordées à la cavité résonante 104, comme on le voit sur la figure 9.

Les dispositifs conformes à l'invention qui ont été décrits en faisant référence aux figures 1 à 9 sont faits de matériaux électriquement conducteurs, par exemple des matériaux métalliques ou des matériaux diélectriques recouverts d'une couche métallique.

Les éléments constitutifs de ces dispositifs sont raccordés les uns aux autres par des soudures continues, réalisées sans aspérités, ou par des raccords étanches ou micro-ondes avec des brides adaptées.

Les parois internes sont très lisses (il est préférable de polir ces parois dans le cas où elles sont faites d'un matériau métallique), et ne comportent ni aspérités ni bosses.

Dans le cas où les parois portant les fentes rayonnantes sont faites d'un matériau métallique, il est préférable que l'épaisseur de ce matériau ne dépasse pas 1 millimètre car une épaisseur supérieure à cette valeur pourrait dégrader la qualité du couplage entre les ondes et le matériau (un plasma par exemple).

Il est également préférable que le pourtour des fentes soit arrondi, lisse et sans angles vifs.

De plus, il est préférable que chaque court-circuit soit relié aux parois de la cavité par des soudures métalliques sur ses quatre côtés, lorsqu'il est en regard de parois sans fentes, ou sur trois côtés lorsqu'il est situé au niveau d'une fente rayonnante, le matériau métallique constitutif du court-circuit étant, dans ce dernier cas, lisse et arrondi sur le bord qui est en regard de la fente.

## Revendications

1. Dispositif d'application de micro-ondes à un matériau, dispositif caractérisé en ce qu'il comprend au moins un module (32) d'application des micro-ondes au matériau, ce module comprenant :
- une cavité résonante (2, 20, 84, 104) sensiblement en forme de couronne et délimitée par des parois interne (4), externe (6), inférieure (8) et supérieure (10) qui sont électriquement conductrices, et
- au moins un guide d'ondes (12, 22, 80, 86, 100) prévu pour amener les micro-ondes dans cette cavité résonante, les dimensions de la section de la cavité par un plan contenant l'axe de cette cavité étant choisies en fonction des dimensions de la section transversale du guide d'ondes de façon que le mode qui se propage dans la cavité soit identique au mode de propagation des micro-ondes dans le guide d'ondes, et en ce qu'au moins l'une des parois de la cavité résonante est pourvue de fentes rayonnantes (14, 16, 94) qui sont espacées les unes des autres d'une distance au plus égale à Lg/2 où Lg est la longueur d'onde des micro-ondes dans le guide d'ondes, ce guide d'ondes ayant lui-même une longueur au moins égale à Lg/2,
de façon à transférer, à travers ces fentes, de l'énergie électro-magnétique au matériau disposé à cet effet en regard de la paroi portant les fentes rayonnantes.

2. Dispositif selon la revendication 1, caractérisé en ce que les fentes rayonnantes (14, 16) sont situées sur l'une au moins des parois interne (4) et externe (6).

3. Dispositif selon la revendication 1, caractérisé en ce que les fentes rayonnantes (94) sont situées sur l'une au moins des parois inférieure (8) et supérieure (10).

4. Dispositif selon l'une quelconque des revendications 1 à 3, caractérisé en ce que l'une au moins des parois interne (4) et externe (6) est cylindrique.

5. Dispositif selon l'une quelconque des revendications 1 à 4, caractérisé en ce que la paroi interne est en forme de polyèdre régulier.

6. Dispositif selon l'une quelconque des revendications 1 à 5, caractérisé en ce que la paroi externe (6) est en forme de polyèdre régulier, ayant ainsi une pluralité de facettes identiques (31), et en ce que la longueur de ces facettes est au moins égale à Lg/4.

7. Dispositif selon l'une quelconque des revendications 1 à 6, caractérisé en ce que le guide d'ondes (22, 86) est prolongé par un cornet sectoral (24) suivi par un duplexeur (26) qui amène les micro-ondes à la cavité résonante (20) et en ce que la longueur de l'ensemble (24-26, 88) formé par le cornet sectoral et le duplexeur est au moins égale à Lg/2.

8. Dispositif selon l'une quelconque des revendications 1 à 7, caractérisé en ce qu'il comprend en outre au moins un court-circuit fixe (18, 28, 30, 90, 92, 102, 110) pour chaque guide d'ondes (12, 22, 86, 100), ce court-circuit fixe formant un obstacle plan électriquement conducteur qui est perpendiculaire aux parois inférieure (8) et supérieure (10) de la cavité résonante et qui s'étend sur toute la section de celle-ci par un plan contenant l'axe de la cavité.

9. Dispositif selon les revendications 7 et 8, caractérisé en ce qu'il comprend deux tels courts-circuits, l'un étant disposé entre les entrées de micro-ondes, entrées qui sont respectivement associées aux branches du duplexeur, et l'autre étant symétrique du précédent par rapport à l'axe de la cavité.

10. Dispositif selon l'une quelconque des revendications 1 à 9, caractérisé en ce qu'il comprend en outre une plaque ou une grille (46) électriquement conductrice qui ferme la partie supérieure de ce dispositif.

11. Réacteur à plasma comprenant :
- une enceinte (34, 66, 96) dont au moins une partie (40, 68, 98) est faite d'un matériau transparent aux micro-ondes et qui est prévue pour recevoir un gaz plasmagène, et
- un dispositif (32) d'application de micro-ondes au gaz, ce dispositif étant disposé en regard de la partie faite d'un matériau transparent aux micro-ondes , de façon à engendrer un plasma dans l'enceinte et à traiter, grâce à ce plasma, un ou plusieurs échantillons (44) placés dans l'enceinte, ce réacteur étant caractérisé en ce que le dispositif d'application des micro-ondes est conforme à l'une quelconque des revendications 1 à 10.

12. Réacteur selon la revendication 11, caractérisé en ce que les fentes (14) du dispositif (32) sont situées sur la paroi interne (4) de la cavité résonante (2) et en ce que ladite partie (40, 68) du réacteur est entourée par le dispositif.

13. Réacteur selon la revendication 12, caractérisé en ce que ce réacteur comprend une pluralité de modules (32) qui sont placés les uns à la suite des autres et qui entourent ladite partie (68) du réacteur.

14. Réacteur selon la revendication 11, caractérisé en ce que les fentes (94) du dispositif sont situées sur la paroi inférieure de la cavité résonante (84) et en ce que ladite partie (98) du réacteur est placée en regard de cette paroi inférieure.

## Patentansprüche

1. Vorrichtung zur Anwendung von Mikrowellen auf ein Material, wobei diese Vorrichtung
**dadurch gekennzeichnet** ist, daß sie wenigstens einen Anwendungsmodul (32) der Mikrowellen auf das Material enthält und dieser Modul umfaßt:
- einen Hohlraumresonator (2, 20, 84, 104), im wesentlichen ringförmig und begrenzt durch die Wände innen (4), außen (6), unten (8) und oben (10), die elektrisch leitend sind, und
- wenigstens einen Wellenleiter (12, 22, 80, 86, 100), vorgesehen um diese Mikrowellen in den Hohlraumresonator zu leiten, wobei die Abmessungen des Querschnitts des Resonators in einer Ebene, die die Achse dieses Resonators enthält, gewählt wird in Abhängigkeit von den Abmessungen des querverlaufenden Querschnitts des Wellenleiters, so daß der Wellentyp, der sich in dem Resonator fortpflanzt, identisch ist mit dem Fortpflanzungswellentyp der Mikrowellen in dem Wellenleiter,
und dadurch, daß wenigstens eine der Wände des Hohlraumresonators versehen ist mit ausstrahlenden Schlitzen (14, 16, 94), die voneinander beabstandet sind um eine Distanz von höchstens gleich Lg/2, wo Lg die Wellenlänge der Mikrowellen in dem Wellenleiter ist, wobei dieser Wellenleiter selbst eine Länge von wenigstens gleich Lg/2 hat,
um durch diese Schlitze elektromagnetische Energie auf das Material zu übertragen, das zu diesem Zweck der Wand gegenüber angeordnet ist, welche die ausstrahlenden Schlitze aufweist.

2. Vorrichtung nach Anspruch 1, dadurch gekennzeichnet, daß die ausstrahlenden Schlitze (14, 16) sich auf wenigstens einer der beiden Wände innen (4) und außen (6) befinden.

3. Vorrichtung nach Anspruch 1, dadurch gekennzeichnet, daß die ausstrahlenden Schlitze (94) sich auf wenigstens einer der beiden Wände unten (8) und oben (10) befinden.

4. Vorrichtung nach einem der Ansprüche 1 bis 3, dadurch gekennzeichnet, daß wenigstens eine der Wände innen (4) und außen (6) zylindrisch ist.

5. Vorrichtung nach einem der Ansprüche 1 bis 4, dadurch gekennzeichnet, daß die innere Wand die Form eines gleichmäßigen Polyeders hat.

6. Vorrichtung nach einem der Ansprüche 1 bis 5, dadurch gekennzeichnet, daß die äußere Wand (6) die Form eines gleichmässigen Polyeders hat und somit eine Vielzahl identischer Facetten (31) aufweist, und dadurch, daß die Länge dieser Facetten wenigstens gleich Lg/4 ist.

7. Vorrichtung nach einem der Ansprüche 1 bis 6, dadurch gekennzeichnet, daß der Wellenleiter (22, 86) verlängert wird durch ein Sektorhorn (24), gefolgt von einem Duplexer (26), der die Mikrowellen in den Hohlraumresonator (20) leitet, und dadurch, daß die Länge des durch das Sektorhorn und den Duplexer gebildeten Ganzen (24-26, 88) wenigstens gleich Lg/2 ist.

8. Vorrichtung nach einem der Ansprüche 1 bis 7, dadurch gekennzeichnet, daß sie außerdem wenigstens einen festen Schluß bzw. Kurzschluß (18, 28, 30, 90, 92, 102, 110) für jeden Wellenleiter (12, 22, 86, 100) umfaßt, wobei dieser feste Kurzschluß ein ebenes, elektrisch leitendes Hindernis bildet, das senkrecht ist zu der unteren (8) und der oberen (10) Wand des Hohlraumresonators, und das sich in einer Ebene, die die Achse des Resonators enthält, über dessen gesamten Querschnitt ausdehnt.

9. Vorrichtung nach einem der Ansprüche 7 und 8, dadurch gekennzeichnet, daß sie zwei derartige Kurzschlüsse umfaßt, wobei einer angeordnet ist zwischen den Mikrowelleneingängen, die jeweils den Zweigen des Duplexers zugeordnet sind, und der andere symetrisch ist zum vorhergehenden in bezug auf die Achse des Resonators.

10. Vorrichtung nach einem der Ansprüche 1 bis 9, dadurch gekennzeichnet, daß sie außerdem eine Platte oder ein Gitter (46) umfaßt, elektrisch leitend und den Oberteil dieser Vorrichtung schließend.

11. Plasmareaktor, umfassend:
- einen Behälter (34, 66, 96), von dem wenigstens ein Teil (40, 68, 98) aus einem mikrowellendurchlässigen Material gemacht ist und der vorgesehen ist, ein plasmagenes Gas bzw. ein Plasmid-Gas aufzunehmen, und
- eine Vorrichtung (32) zur Anwendung von Mikrowellen auf Gas, wobei diese Vorrichtung einem mikrowellendurchlässigen Teil gegenüber angeordnet, um in dem Behälter ein Plasma zu erzeugen und mit diesem Plasma ein oder mehrere in dem Behälter befindliche Proben (44) zu behandeln, wobei dieser Reaktor dadurch gekennzeichnet ist, daß die Mikrowellen-Anwendungsvorrichtung einem der Ansprüche 1 bis 10 entspricht.

12. Reaktor nach Anspruch 11, dadurch gekennzeichnet, daß die Schlitze (14) der Vorrichtung (32) sich auf der inneren Wand (4) des Hohlraumresonators (2) befinden und dadurch, daß besagter Teil (40, 68) des Reaktors von der Vorrichtung umgeben ist.

13. Reaktor nach Anspruch 12, dadurch gekennzeichnet, daß dieser Reaktor eine Vielzahl Module (32) umfaßt, die nacheinander angeordnet sind und die den besagten Teil (68) des Reaktors umgeben.

14. Reaktor nach Anspruch 11, dadurch gekennzeichnet, daß die Schlitze (94) der Vorrichtung sich auf der unteren Wand des Hohlraumresonators (84) befinden, und dadurch, daß der Teil (98) des Reaktors dieser unteren Wand gegenüber angeordnet ist.

## Claims

1. Device for applying microwaves to a material, which device is characterized in that it comprises at least one module (32) for applying the microwaves to the material, this module comprising:
- a resonant cavity (2, 20, 84, 104), substantially in the shape of a ring and bounded by inner (4), outer (6), lower (8) and upper (10) walls which are electrically conductive, and
- at least one waveguide (12, 22, 80, 86, 100) designed to convey the microwaves into this resonant cavity, the dimensions of the section of the cavity through a plane containing the axis of this cavity being chosen as a function of the dimensions of the cross-section of the waveguide, so that the mode propagating in the cavity is identical to the propagation mode of the microwaves in the waveguide,
and in that at least one of the walls of the resonant cavity is provided with radiating slots (14, 16, 94) which are spaced apart from one another by a difference at most equal to Lg/2, where Lg is the wavelength of the microwaves in the waveguide, this waveguide itself having a length at least equal to Lg/2, so as to transfer electromagnetic energy through these slots to the material arranged for this purpose facing the wall bearing the radiating slots.

2. Device according to Claim 1, characterized in that the radiating slots (14, 16) are situated on at least one of the inner (4) and outer (6) walls.

3. Device according to Claim 1, characterized in that the radiating slots (94) are situated on at least one of the lower (8) and upper (10) walls.

4. Device according to any one of Claims 1 to 3, characterized in that at least one of the inner (4) and outer (6) walls is cylindrical.

5. Device according to any one of Claims 1 to 4, characterized in that the inner wall is in the shape of a regular polyhedron.

6. Device according to any one of Claims 1 to 5, characterized in that the outer wall (6) is in the shape of a regular polyhedron, thus having a plurality of identical facets (31), and in that the length of these facets is at least equal to Lg/4.

7. Device according to any one of Claims 1 to 6, characterized in that the waveguide (22, 86) is extended by a sectoral horn (24) followed by a duplexer (26) which conveys the microwaves to the resonant cavity (20) and in that the length of the assembly (24-26, 88) formed by the sectoral horn and the duplexer is at least equal to Lg/2.

8. Device according to any one of Claims 1 to 7, characterized in that it furthermore comprises at least one fixed short-circuit (18, 28, 30, 90, 92, 102, 110) for each waveguide (12, 22, 86, 100), this fixed short-circuit forming an electrically conductive plane obstacle which is perpendicular to the lower (8) and upper (10) walls of the resonant cavity and which extends over the entire section thereof through a plane containing the axis of the cavity.

9. Device according to Claims 7 and 8, characterized in that it comprises two such short-circuits, one being arranged between the microwave inputs, which inputs are respectively associated with the branches of the duplexer, and the other being symmetrical with the former with respect to the axis of the cavity.

10. Device according to any one of Claims 1 to 9, characterized in that it furthermore comprises an electrically conductive plate or grille (46) which closes the upper part of this device.

11. Plasma reactor comprising:
- an enclosure (34, 66, 96), at least a part (40, 68, 98) of which is made of a microwave-transparent material and which is designed to hold a plasma-generating gas, and
- a device (32) for applying microwaves to the gas, this device being arranged facing the part made of a microwave-transparent material, so as to generate a plasma in the enclosure and, by virtue of this plasma, to process one or more samples (44) placed in the enclosure, this reactor being characterized in that the microwave application device is in accordance with any one of Claims 1 to 10.

12. Reactor according to Claim 11, characterized in that the slots (14) of the device (32) are situated on the inner wall (4) of the resonant cavity (2), and in that the said part (40, 68) of the reactor is surrounded by the device.

13. Reactor according to Claim 12, characterized in that this reactor comprises a plurality of modules (32) which are placed one after the other and which surround the said part (68) of the reactor.

14. Reactor according to Claim 11, characterized in that the slots (94) of the device are situated on the lower wall of the resonant cavity (84), and in that the said part (98) of the reactor is placed facing this lower wall.
